# EUROPÄISCHE PATENTSCHRIFT

(11) **EP 1 552 566 B1**
(45) Veröffentlichungstag und Bekanntmachung des Hinweises auf die Patenterteilung: **08.03.2006**
(21) Anmeldenummer: 03757670.9
(22) Anmeldetag: 17.09.2003
(51) Int. Cl.: H01L 41/04, F02D 41/20

(54) **SCHALTUNG MIT MINDESTENS EINEM PIEZOAKTOR**
CIRCUIT WITH AT LEAST ONE PIEZOELECTRIC ACTUATOR
CIRCUIT DOTE D'AU MOINS UN ACTIONNEUR PIEZO-ELECTRIQUE

(30) Priorität: 16.10.2002 DE 10248214
(43) Veröffentlichungstag der Anmeldung: 13.07.2005
(73) Patentinhaber: Volkswagen Mechatronic GmbH & Co., 09366 Stollberg (DE)
(72) Erfinder: LIXL, Heinz, 93053 Regensburg (DE); PIRKL, Richard, 93047 Regensburg (DE)
(74) Vertreter: Beck, Josef
(86) Internationale Anmeldenummer: PCT/DE2003/003089
(87) Internationale Veröffentlichungsnummer: WO 2004/036662

(56) Entgegenhaltungen:
- EP-A- 0 371 469
- US-A- 4 767 959
- US-A1- 2002 011 762

## Beschreibung

Die vorliegende Erfindung betrifft eine Schaltung mit mindestens einem Piezoaktor, einer Ansteuerschaltung, einer Korrekturschaltung und einer Steuerschaltung,
- wobei ein Piezoaktor im beaufschlagungsfreien Zustand eine Nulllage einnimmt ,
- wobei bei Vorgabe eines Ansteuerbefehls durch die Steuerschaltung von der Ansteuerschaltung ein Ansteuersignal an den Piezoaktor abgebbar ist, aufgrund dessen der Piezoaktor in eine Ansteuerlage überführbar ist,
- wobei bei Vorgabe eines Korrekturbefehls durch die Steuerschaltung von der Korrekturschaltung ein Korrektursignal an den Piezoaktor abgebbar ist, aufgrund dessen der Piezoaktor aus der Nulllage in eine Korrekturlage überführbar ist.

Eine derartige Schaltung ist beispielsweise aus der DE 199 05 340 C2 bekannt. Die dort beschriebene Schaltung funktioniert bereits zufriedenstellend. Sie ist aber vergleichsweise komplex aufgebaut, weil bei dieser Schaltung eine additive Überlagerung des Ansteuersignals und des Korrektursignals erforderlich ist. Das Überführen in die Korrekturlage dient dabei hauptsächlich dem Zweck, während der Ansteuerpausen eine definierte Ruhelage des Piezoaktors zu erreichen.

Die US 4,767,959 beschreibt ein Verfahren und eine Vorrichtung zum Ansteuern einer kapazitiven Last, insbesondere eines piezoelektrischen Aktors. Es wird insbesondere die Erzeugung eines Voreinspritzsignals und eines Haupteinspritzsignal s zur Erzeugung einer Voreinspritzung und einer Haupteinspritzung beschrieben.

Die DE 199 05 340 C2 beschreibt ein Verfahren und eine Anordnung zur Voreinstellung und dynamischen Nachführung piezoelektrischer Aktoren. Der elektrischen Ansteuerspannung des Aktors zur dynamischen Auslenkung wird ein davon unabhängiger steuerbarer Gleichspannungsanteil überlagert. Die dynamische pulsförmige Anregungsspannung und die Gleichspannung werden in einer Summationsschaltung zu einer Spannung überlagert, welche an den Piezoaktor angelegt wird.

Die DE 198 27 170 A1 beschreibt ein Verfahren und eine Vorrichtung zum Steuern eines piezoelektrischen Elements auf eine wunschgemäße Ausdehnung. Sie sieht eine Mehrzahl von Piezoelementen vor, die unabhängig voneinander über Auswahlschalter angesteuert werden können.

Die DE 100 12 607 C2 beschreibt ein Verfahren zur Ansteuerung eines kapazitiven Stellglieds, insbesondere eines piezoelektrisch betriebenen Kraftstoffeinspritzventils einer Brennkraftmaschine. Ein Leerhub des piezoelektrischen Stellglieds wird durch Zuführen einer Ladung kompensiert.

Die Aufgabe der vorliegenden Erfindung besteht darin, eine gattungsgemäße Schaltung derart weiterzubilden, dass bei ihr mit geringerem Aufwand im wesentlichen das gleiche Ergebnis erzielbar ist.

Die Aufgabe wird dadurch gelöst, dass die Steuerschaltung derart ausgebildet ist, dass die Vorgabe des Ansteuerbefehls und die Vorgabe des Korrekturbefehls gegeneinander verriegelt sind.

Die vorliegende Erfindung beruht also auf der Erkenntnis, dass für viele Anwendungen der durch das Ansteuersignal bewirkte Hub relativ zur Korrekturlage zweitrangig ist. Wichtiger ist vielmehr, dass während der Nichtansteuerung des Piezoaktors die Korrekturlage eingenommen wird. Dies wird auch bei der erfindungsgemäßen Ausgestaltung erreicht. Durch die erfindungsgemäße Ausgestaltung kann hingegen auf eine Überlagerungsstufe, in der eine Addition von Ansteuersignal und Korrektursignal erfolgt, entfallen.

Es ist möglich, dass die Korrekturschaltung eine erste und eine zweite Teilschaltung aufweist, die Steuerschaltung derart ausgebildet ist, dass der Korrekturbefehl alternativ an die erste oder an die zweite Teilschaltung ausgebbar ist, dass die erste Teilschaltung derart ausgebildet und angeordnet ist, dass bei Vorgabe des Korrekturbefehls an die erste Teilschaltung die Korrekturlage zwischen der Nulllage und der Ansteuerlage liegt, und dass die zweite Teilschaltung derart ausgebildet und angeordnet ist, dass bei Vorgabe des Korrekturbefehls an die zweite Teilschaltung die Nulllage zwischen der Korrekturlage und der Ansteuerlage liegt. In diesem Fall ist ein Einstellen der Korrekturlage bezüglich der Nulllage in beide Richtungen möglich.

Alternativ ist es auch möglich, dass die Korrekturschaltung derart ausgebildet und angeordnet ist, dass die Korrekturlage stets zwischen der Nulllage und der Ansteuerlage liegt bzw. dass die Nulllage stets zwischen der Korrekturlage und der Ansteuerlage liegt. Insbesondere im letzten Fall ergibt sich eine technisch einfache Korrekturschaltung mit deutlich hinreichender Effizienz. Denn eine Auslenkung in Richtung der Ansteuerlage ist in aller Regel nicht erforderlich.

Die Korrekturschaltung kann als Korrektursignalsteuerung und/oder als Korrektursignalregelung ausgebildet sein, je nach dem, ob das Korrektursignal in die Korrekturschaltung rückgekoppelt wird oder nicht. Die Umschaltung zwischen Steuern und Regeln des Korrektursignals kann in diesem Fall betriebszustandsabhängig erfolgen. Vorzugsweise ist die Umschaltung hysteresebehaftet.

Wenn der Steuerschaltung ein Lagesignal zuführbar ist, anhand dessen von der Steuerschaltung eine Solllage ermittelbar ist, und die Steuerschaltung derart ausgebildet ist, dass von ihr anhand der Solllage ein korrespondierender Korrekturbefehl ermittelbar ist, arbeitet die Schaltung besonders gut. Dies gilt ganz besonders, wenn das Lagesignal ein aus dem Überführen des Piezoaktors in die Ansteuerlage abgeleitetes Signal ist. Denn in diesem Fall erfolgt ein geregeltes Einstellen der Korrekturlage.

Wenn die Korrekturschaltung derart ausgebildet ist, dass das Korrektursignal von ihr auf einen Grenzwert begrenzt wird, bei dem keine Depolarisierung des Piezoaktors erfolgt, weist der Piezoaktor eine besonders lange Lebensdauer auf. Ein zuverlässiges, stabiles Schaltverhalten ist also für lange Zeit gewährleistet. Der Grenzwert kann beispielsweise bei 30 Volt oder darunter liegen.

In der Regel sind die Ansteuerschaltung und die Korrekturschaltung mit einem Gleichspannungsnetz verbindbar. In diesem Fall ergibt sich eine vorteilhafte Ausgestaltung der Schaltung dadurch, dass sie einen Spannungswandler aufweist, der zwischen dem Gleichspannungsnetz einerseits und der Ansteuerschaltung und der Korrekturschaltung andererseits angeordnet ist.

Wenn die Schaltung mehrere Piezoaktoren aufweist, weist sie vorzugsweise eine von der Steuerschaltung ansteuerbare Schalteinrichtung auf, so dass steuerbar ist, an welchen der Piezoaktoren das Ansteuersignal abgegeben wird. Denn dann ergibt sich ein minimaler Schaltungsaufwand.

Der Schaltungsaufwand kann noch weiter verringert werden, wenn mittels der Schalteinrichtung auch steuerbar ist, an welchen der Piezoaktoren das Korrektursignal abgegeben wird.

Ein häufiger Anwendungsfall der erfindungsgemäßen Schaltung besteht in der Steuerung der Einspritzung bei einer Verbrennungskraftmaschine.

Weitere Vorteile und Einzelheiten ergeben sich aus der nachfolgenden Beschreibung eines Ausführungsbeispiels in Verbindung mit den Zeichnungen. Dabei zeigen in Prinzipdarstellung
- FIG 1: ein Blockschaltbild einer Schaltung mit mehreren Piezoaktoren und
- FIG 2: ein Steuerdiagramm.

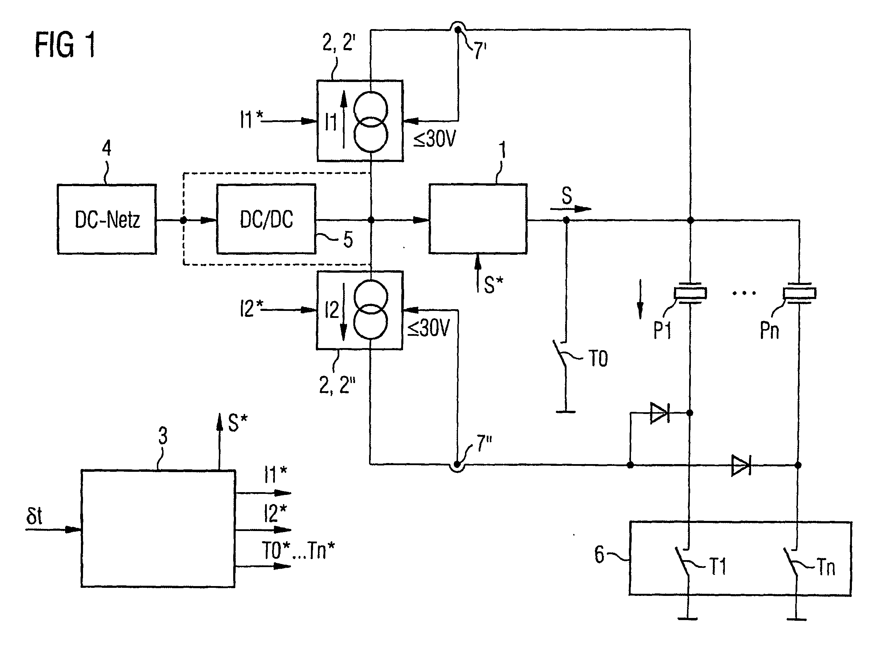

Gemäß FIG 1 weist eine Schaltung mehrere Piezoaktoren P1 bis Pn auf. Sie weist ferner eine Ansteuerschaltung 1, eine Korrekturschaltung 2 und eine Steuerschaltung 3 auf. Die Korrekturschaltung 2 weist eine erste Teilschaltung 2' und eine zweite Teilschaltung 2" auf.

Die Ansteuerschaltung 1 und die Korrekturschaltung 2 sind mit einem Gleichspannungsnetz 4 verbindbar. Die Schaltung kann dabei optional einen Spannungswandler 5 aufweisen, der zwischen dem Gleichspannungsnetz 4 auf der einen Seite und der Ansteuerschaltung 1 und der Korrekturschaltung 2 auf der anderen Seite angeordnet ist. Der Spannungswandler 5 ist typischerweise als Schaltnetzteil 5 ausgebildet. Er setzt die Netzspannung auf eine höhere Spannung um.

Die Schaltung von FIG 1 wird in der Regel zur Steuerung der Einspritzung bei einer Verbrennungskraftmaschine verwendet. Die Netzspannung des Gleichspannungsnetzes 4 beträgt daher in der Regel 12 oder 24 Volt. Die Ausgangsspannung des Spannungswandlers 5 ist üblicherweise größer als die Netzspannung. Sie liegt beispielsweise im Bereich zwischen 60 und 100 Volt.

Auch die Steuerschaltung 3 wird üblicherweise vom Gleichspannungsnetz 4 aus mit Energie versorgt. Dies ist in FIG 1 lediglich der Übersichtlichkeit halber nicht mit dargestellt.

Die Steuerschaltung 3 gibt verschiedene Steuersignale aus. Es sind dies zum einen ein Ansteuerbefehl S*, der der Ansteuerschaltung 1 vorgebbar ist. Ferner sind dies Korrekturbefehle I1*, I2*, welche der ersten bzw. zweiten Teilschaltung 2', 2" vorgebbar sind. Schließlich sind es Schaltbefehle T0* bis Tn*, welche korrespondierenden Schaltern T0 bis Tn einer Schalteinrichtung 6 vorgebbar sind.

Wenn der Ansteuerschaltung 1 durch die Steuerschaltung 3 der Ansteuerbefehl S* vorgegeben wird, wird von der Ansteuerschaltung 1 ein Ansteuersignal S an einen der Piezoaktoren P1 bis Pn abgegeben. Gleichzeitig wird von der Steuerschaltung 3 ein Schaltbefehl Ti* an einen der Schalter T0 bis Tn abgegeben. Die Schalteinrichtung 6 ist also von der Steuerschaltung 3 ansteuerbar. Durch das Ansteuern eines der Schalter T0 bis Tn wird gesteuert, an welchen der Piezoaktoren P1 bis Pn das Ansteuersignal S abgegeben wird. Der angesteuerte Piezoaktor Pi wird aufgrund des Ansteuersignals S aus einer Nulllage in eine Ansteuerlage überführt. Die Nulllage entspricht dabei der Lage des Piezoaktors Pi, die dieser im beaufschlagungsfreien Zustand (angelegte Spannung = 0V, fließender Strom = 0A) annimmt.

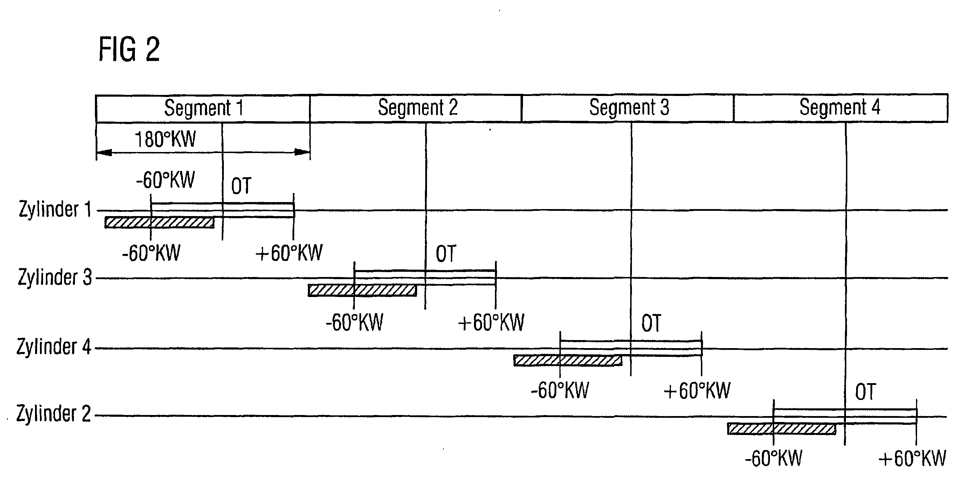

Die Ansteuerung der Piezoaktoren P1 bis Pn ist beispielhaft in FIG 2 für einen Vierzylinder-Viertaktmotor dargestellt. Das Kürzel "KW" steht dabei für Kurbelwelle, das Kürzel "OT" für oberer Totpunkt. Die nicht ausgefüllten Kästen in FIG 2 bedeuten den Winkelbereich, innerhalb dessen eine Einspritzung in einen der Zylinder des Motors erfolgen kann. Ersichtlich kann eine Einspritzung - bezogen auf den jeweiligen Zylinder - innerhalb des Bereichs von 60° vor dem oberen Totpunkt bis 60° nach dem oberen Totpunkt erfolgen.

Wenn durch die Steuerschaltung 3 ein Korrekturbefehl I1* bzw. I2* an die erste bzw. zweite Teilschaltung 2', 2" vorgegeben wird, wird von der angesteuerten Teilschaltung 2', 2" ein Korrektursignal I1 bzw. I2 an die Piezoaktoren P1 bis Pn abgegeben.

Die Steuerschaltung 3 ist derart ausgebildet, dass sie alternativ an die erste oder an die zweite Teilschaltung 2', 2" einen Korrekturbefehl I1*, I2* abgibt. Zu keinem Zeitpunkt wird also ein Korrekturbefehl I1*, I2* an beide Teilschaltungen 2', 2" abgegeben.

Bei Vorgabe des Korrekturbefehls I1* an die erste Teilschaltung 2' wird gleichzeitig einer der Schalter T1 bis Tn durch einen entsprechenden Schaltbefehl Ti* angesteuert. Dadurch wird mittels der Schalteinrichtung 6 gesteuert, an welchen der Piezoaktoren P1 bis Pn das Korrektursignal I1 abgegeben wird. Durch dieses Korrektursignal I1 wird der angesteuerte Piezoaktor Pi aus der Nulllage in eine Korrekturlage überführt, die zwischen der Nulllage und der Ansteuerlage liegt.

Wenn von der Steuerschaltung 3 der Korrekturbefehl I2* an die zweite Teilschaltung 2" abgegeben wird, wird von dieser ein Korrektursignal I2 abgegeben. In diesem Fall werden die Schalter T1 bis Tn nicht angesteuert. Hingegen wird von der Steuerschaltung 3 der Schalter T0 geschlossen. Dadurch werden alle Piezoaktoren P1 bis Pn gleichermaßen angesteuert. In diesem Fall erfolgt eine Negativauslenkung der Piezoaktoren P1 bis Pn. Die Nulllage liegt also in diesem Fall zwischen der Korrekturlage und der Ansteuerlage der Piezoaktoren P1 bis Pn.

Wie aus FIG 2 ersichtlich ist, beginnen die Bereiche innerhalb derer der Korrekturschaltung 2 ein Korrekturbefehl I1*, I2* vorgegeben werden kann, bezüglich jedes Zylinders bei ca. 80° vor dem oberen Totpunkt. Die Bereiche - in FIG 2 schraffiert eingezeichnet - erstrecken sich bis kurz vor den oberen Totpunkt des jeweiligen Zylinders. In der Regel enden sie spätestens 10° vor dem oberen Totpunkt. In jedem Fall aber wird durch die Steuerschaltung 3 gewährleistet, dass der Ansteuerbefehl S* erst dann vorgegeben wird, wenn die Vorgabe des Korrekturbefehls I1* bzw. I2* beendet ist. Die Steuerschaltung 3 ist also derart ausgebildet, dass die Vorgabe des Ansteuerbefehls S* und die Vorgabe des Korrekturbefehls I1* bzw. I2* gegeneinander verriegelt sind.

Gemäß FIG 1 werden die Korrektursignale I1, I2, die von den Teilschaltungen 2', 2" abgegeben werden, an Messstellen 7', 7" erfasst und wieder den Teilschaltungen 2', 2" zugeführt. Diese sind somit als Korrektursignalregelungen ausgebildet, da sie das abgegebene Korrektursignal I1 bzw. I2 nachregeln können, bis es den gewünschten Wert des Korrekturbefehls I1*, I2* annimmt. Die Messstellen 7', 7" könnten aber auch entfallen. In diesem Fall wären die Teilschaltungen 2', 2" als Korrektursignalsteuerungen ausgebildet.

Es ist ferner möglich, direkt oder indirekt ein Lagesignal δt zu messen, welches charakteristisch für eine optimale Korrekturlage ist. Beispielsweise kann eine Zeitdifferenz δt erfasst werden, die zwischen dem Beginn der Ausgabe des Ansteuerbefehls S* und dem tatsächlichen Aufsetzen des angesteuerten Piezoaktors Pi auf einem zu betätigenden Stößel vergeht. Diese Zeitdifferenz δt ist charakteristisch für den Abstand der Nulllage vom Stößel. Die Zeitdifferenz δt ist also ein Signal, das aus dem Überführen des Piezoaktors Pi in die Ansteuerlage abgeleitet wird.

Anhand des Lagesignals δt ist von der Steuerschaltung 3 eine Solllage für die Piezoaktoren P1 bis Pn ermittelbar. Die Steuerschaltung 3 kann somit derart ausgebildet sein, dass von ihr anhand des Lagesignals die Solllage und anhand der Solllage der korrespondierende Korrekturbefehl I1* bzw. I2* ermittelbar ist.

Gemäß FIG 1 wird sowohl das Korrektursignal I1 als auch das Korrektursignal I2 von den Teilschaltungen 2', 2" auf einen Grenzwert begrenzt, der kleiner oder maximal gleich 30 Volt ist. Durch diese Bemessung der Korrektursignale I1, I2 wird gewährleistet, dass durch die Korrektursignale I1, I2 keine Depolarisierung des jeweiligen angesteuerten Piezoaktors Pi erfolgt.

Bei der Ausführungsform gemäß FIG 1 weist die Korrekturschaltung 2 zwei Teilschaltungen 2', 2" auf. Gegebenenfalls könnte aber auch eine der beiden Teilschaltungen 2', 2" entfallen. Welche der beiden Teilschaltungen 2', 2" entfallen kann, ist dabei eine Frage der Auslegung der Piezoaktoren P1 bis Pn sowie der sonstigen mechanischen Gegebenheiten des Systems.

Mittels der vorliegenden Erfindung ist insbesondere im Anwendungsfall der Steuerung der Einspritzung bei einer Verbrennungskraftmaschine, insbesondere bei Pumpe-Düse-Systemen, auf einfache Weise eine unerwünschte Autoinjektion während der Einspritzpausen der einzelnen Zylinder verhinderbar. Ferner werden durch die Vermeidung eines "offen stehenden" Servoventils Startprobleme aufgrund unzureichenden Druckaufbaus vermieden.

## Patentansprüche

1. Schaltung mit mindestens einem Piezoaktor (P1 bis Pn), einer Ansteuerschaltung (1), einer Korrekturschaltung (2) und einer Steuerschaltung (3),
- wobei ein Piezoaktor (P1 bis Pn) im beaufschlagungsfreien Zustand eine Nulllage einnimmt,
- wobei bei Vorgabe eines Ansteuerbefehls (S*) durch die Steuerschaltung (3) von der Ansteuerschaltung (1) ein Ansteuersignal (S) an den Piezoaktor (Pi) abgebbar ist, aufgrund dessen der Piezoaktor (Pi) aus der Nulllage in eine Ansteuerlage überführbar ist,
- wobei bei Vorgabe eines Korrekturbefehls (I1*, I2*) durch die Steuerschaltung (3) von der Korrekturschaltung (2) ein Korrektursignal (I1, I2) an den Piezoaktor (Pi) abgebbar ist, aufgrund dessen der Piezoaktor (Pi) aus der Nulllage in eine Korrekturlage überführbar ist,
- wobei die Steuerschaltung (3) derart ausgebildet ist, dass die Vorgabe des Ansteuerbefehls (S*) und die Vorgabe des Korrekturbefehls (I1*, I2*) gegeneinander verriegelt sind.

2. Schaltung nach Anspruch 1,
**dadurch gekennzeichnet,**
- **dass** die Korrekturschaltung (2) eine erste und eine zweite Teilschaltung (2', 2") aufweist,
- **dass** die Steuerschaltung (3) derart ausgebildet ist, dass der Korrekturbefehl (I1*, I2*) alternativ an die erste oder an die zweite Teilschaltung (2', 2") ausgebbar ist,
- **dass** die erste Teilschaltung (2') derart ausgebildet und angeordnet ist, dass bei Vorgabe des Korrekturbefehls (I1*) an die erste Teilschaltung (2') die Korrekturlage zwischen der Nulllage und der Ansteuerlage liegt, und
- **dass** die zweite Teilschaltung (2") derart ausgebildet und angeordnet ist, dass bei Vorgabe des Korrekturbefehls (I2*) an die zweite Teilschaltung (2") die Nulllage zwischen der Korrekturlage und der Ansteuerlage liegt.

3. Schaltung nach Anspruch 1,
**dadurch gekennzeichnet,**
**dass** die Korrekturschaltung (2) derart ausgebildet und angeordnet ist, dass die Korrekturlage stets zwischen der Nulllage und der Ansteuerlage liegt.

4. Schaltung nach Anspruch 1,
**dadurch gekennzeichnet,**
**dass** die Korrekturschaltung (2) derart ausgebildet und angeordnet ist, dass die Nulllage stets zwischen der Korrekturlage und der Ansteuerlage liegt.

5. Schaltung nach einem der obigen Ansprüche,
**dadurch gekennzeichnet,**
**dass** die Korrekturschaltung (2) als Korrektursignalsteuerung und/oder als Korrektursignalregelung ausgebildet ist.

6. Schaltung nach einem der obigen Ansprüche,
**dadurch gekennzeichnet,**
**dass** der Steuerschaltung (3) ein Lagesignal (δt) zuführbar ist, anhand dessen von der Steuerschaltung (3) eine Solllage ermittelbar ist, und dass die Steuerschaltung (3) derart ausgebildet ist, dass von ihr anhand der Solllage der korrespondierende Korrekturbefehl (I1*, I2*) ermittelbar ist.

7. Schaltung nach Anspruch 6,
**dadurch gekennzeichnet,**
**dass** das Lagesignal (δt) ein aus dem Überführen des Piezoaktors (Pi) in die Ansteuerlage abgeleitetes Signal (δt) ist.

8. Schaltung nach einem der obigen Ansprüche,
**dadurch gekennzeichnet,**
**dass** die Korrekturschaltung (2) derart ausgebildet ist, dass das Korrektursignal (11, 12) von ihr auf einen Grenzwert begrenzt wird, bei dem keine Depolarisierung des Piezoaktors (P1 bis Pn) erfolgt.

9. Schaltung nach Anspruch 8,
**dadurch gekennzeichnet,**
**dass** der Grenzwert kleiner oder maximal gleich 30 Volt ist.

10. Schaltung nach einem der obigen Ansprüche,
**dadurch gekennzeichnet,**
**dass** die Ansteuerschaltung (1) und die Korrekturschaltung (2) mit einem Gleichspannungsnetz (4) verbindbar sind.

11. Schaltung nach Anspruch 10,
**dadurch gekennzeichnet,**
**dass** sie einen Spannungswandler (5) aufweist, der zwischen dem Gleichspannungsnetz (4) einerseits und der Ansteuerschaltung (1) und der Korrekturschaltung (2) andererseits angeordnet ist.

12. Schaltung nach einem der obigen Ansprüche,
**dadurch gekennzeichnet,**
**dass** sie mehrere Piezoaktoren (P1 bis Pn) und eine von der Steuerschaltung (3) ansteuerbare Schalteinrichtung (6) aufweist, so dass steuerbar ist, an welchen der Piezoaktoren (P1 bis Pn) das Ansteuersignal (S) abgegeben wird.

13. Schaltung nach Anspruch 12,
**dadurch gekennzeichnet,**
**dass** mittels der Schalteinrichtung (6) auch steuerbar ist, an welchen der Piezoaktoren (P1 bis Pn) das Korrektursignal (I1, 12) abgegeben wird.

14. Schaltung nach einem der obigen Ansprüche,
**dadurch gekennzeichnet,**
**dass** sie zur Steuerung der Einspritzung bei einer Verbrennungskraftmaschine verwendet wird.

## Claims

1. Circuit with at least one piezoactor (P1 to Pn), a drive circuit (1), a correction circuit (2) and a control circuit (3),
- wherein a piezoactor (P1 to Pn) adopts a zero position in a state free of charge,
- wherein on default of a drive command (S*) by the control circuit (3) a drive signal (S) can be emitted by the drive circuit (1) to the piezoactor (Pi), on the basis of which the piezoactor (Pi) can be transferred out of the zero position into a drive position,
- wherein on default of a correction command (I1*, I2*) by the control circuit (3) a correction signal (I1, I2) can be emitted by the correction circuit (2) to the piezoactor (Pi), on the basis of which the piezoactor (Pi) can be transferred out of the zero position into a correction position,
- wherein the control circuit (3) is constructed in such a way that the default of the drive command (S*) and the default of the correction command (I1*, I2*) are locked against one another.

2. Circuit according to claim 1, **characterised in that**
- the correction circuit (2) has a first and a second partial circuit-(2', 2"),
- the control circuit (3) is constructed in such a way that the correction command (I1*, I2*) can be emitted alternatively to the first or the second partial circuit (2', 2"),
- the first partial circuit (2') is constructed and arranged in such a way that on default of the correction command (I1*) to the first partial circuit (2') the correction position is between the zero position and the drive position and
- the second partial circuit (2") is constructed and arranged in such a way that on default of the correction command (I2*) to the second partial circuit (2") the zero position is between the correction position and the drive position.

3. Circuit according to claim 1, **characterised in that** the correction circuit (2) is constructed and arranged in such a way that the correction position is always between the zero position and the drive position.

4. Circuit according to claim 1, **characterised in that** the correction circuit (2) is constructed and arranged in such a way that the zero position is always between the correction position and the drive position.

5. Circuit according to one of the above claims, **characterised in that** the correction circuit (2) is constructed as an open-loop correction signal control and/or as a closed-loop correction signal control.

6. Circuit according to one of the above claims, **characterised in that** a position signal (δt) can be supplied to the control circuit (3), on the basis of which a desired position can be determined by the control circuit (3) and **in that** the control circuit (3) is constructed in such a way that the corresponding correction command (I1*, I2*) can be determined by it on the basis of the desired position.

7. Circuit according to claim 6, **characterised in that** the position signal (δt) is a signal (δt) derived from the transfer of the piezoactor (Pi) into the drive position.

8. Circuit according to one of the above claims, **characterised in that** the correction circuit (2) is constructed in such a way that the correction signal (I1, I2) is limited by it to a limit value at which no depolarisation of the piezoactor (P1 to Pn) takes place..

9. Circuit according to claim 8, **characterised in that** the limit value is smaller or at the most equal to 30 volts.

10. Circuit according to one of the above claims, **characterised in that** the drive circuit (1) and the correction circuit (2) can be connected to a DC voltage network (4).

11. Circuit according to claim 10, **characterised in that** it has a voltage converter (5), arranged between the DC voltage network (4) on the one hand and the drive circuit (1) and the correction circuit (2) on the other hand.

12. Circuit according to one of the above claims, **characterised in that** it has several piezoactors (P1 to Pn) and a switching device (6) drivable by the control circuit (3), so it is possible to control at which of the piezoactors (P1 to Pn) the drive signal (S) is emitted.

13. Circuit according to claim 12, **characterised in that** by means of the switching device (6) it is also possible to control at which of the piezoactors (P1 to Pn) the correction signal (I1, I2) is emitted.

14. Circuit according to one of the above claims, **characterised in that** it is used to control the injection in an internal combustion engine.

## Revendications

1. Circuit comprenant au moins un actionneur piézo-électrique (P1 à Pn), un circuit de pilotage (1), un circuit de correction (2) et un circuit de commande (3), dans lequel :
- un actionneur piézo-électrique (P1 à Pn) adopte une position zéro dans l'état exempt d'alimentation ;
- si une instruction de pilotage (S*) est prescrite par l'intermédiaire du circuit de commande (3) depuis le circuit de pilotage (1), un signal de pilotage (S) peut être transmis à l'actionneur piézo-électrique (Pi), en raison duquel l'actionneur piézo-électrique (Pi) peut être déplacé depuis la position zéro jusque dans une position de pilotage ;
- si une instruction de correction (I1*, I2*) est prescrite par l'intermédiaire du circuit de commande (3) depuis le circuit de correction (2), un signal de correction (I1, I2) peut être transmis à l'actionneur piézo-électrique (Pi), en raison duquel l'actionneur piézo-électrique (Pi) peut être déplacé depuis la position zéro jusque dans une position de correction ; et
- le circuit de commande (3) est réalisé de sorte que la prescription de l'instruction de pilotage (S*) et la prescription de l'instruction de correction (I1*, I2*) sont verrouillées l'une à l'encontre de l'autre.

2. Circuit selon la revendication 1, **caractérisé en ce que** :
- le circuit de correction (2) présente un premier et un second circuits partiels (2', 2") ;
- le circuit de commande (3) est réalisé de sorte que l'instruction de correction (I1*, I2*) peut être sortie alternativement sur le premier ou sur le second circuits partiels (2', 2") ;
- le premier circuit partiel (2') est réalisé et agencé de sorte que, si l'instruction de correction (I1*) est prescrite sur le premier circuit partiel (2'), la position de correction se trouve entre la position zéro et la position de pilotage ; et
- le second circuit partiel (2") est réalisé et agencé de sorte que, si l'instruction de correction (I2*) est prescrite sur le second circuit partiel (2"), la position de zéro se trouve entre la position de correction et la position de pilotage.

3. Circuit selon la revendication 1, **caractérisé en ce que** le circuit de correction (2) est réalisé et agencé de sorte que la position de correction se trouve toujours entre la position zéro et la position de pilotage.

4. Circuit selon la revendication 1, **caractérisé en ce que** le circuit de correction (2) est réalisé et agencé de sorte que la position zéro se trouve toujours entre la position de correction et la position de pilotage.

5. Circuit selon l'une des revendications ci-dessus, **caractérisé en ce que** le circuit de correction (2) est réalisé comme commande de signal de correction et/ou comme régulation du signal de correction.

6. Circuit selon l'une des revendications ci-dessus, **caractérisé en ce qu'**un signal de position (δt) peut être amené au circuit de commande (3), à l'aide duquel une position de consigne peut être déterminée depuis le circuit de commande (3), et **en ce que** le circuit de commande (3) est réalisé de sorte qu'il est possible de déterminer, depuis lui-même, l'instruction de correction correspondante (I1*, I2*) à l'aide de la position de consigne.

7. Circuit selon la revendication 6, **caractérisé en ce que** le signal de position (δt) est un signal (δt) dérivé depuis le transfert de l'actionneur piézo-électrique (Pi) jusque dans la position de pilotage.

8. Circuit selon l'une des revendications ci-dessus, **caractérisé en ce que** le circuit de correction (2) est réalisé de manière à limiter le signal de correction (I1, I2) à une valeur limite pour laquelle aucune dépolarisation de l'actionneur piézo-électrique (P1 à Pn) n'a lieu.

9. Circuit selon la revendication 8, **caractérisé en ce que** la valeur limite est inférieure ou au maximum égale à 30 volts.

10. Circuit selon l'une des revendications ci-dessus, **caractérisé en ce que** le circuit de pilotage (1) et le circuit de correction (2) peuvent être reliés par un réseau de tension continue (4).

11. Circuit selon la revendication 10, **caractérisé en ce qu'**il présente un convertisseur de tension (5) qui est agencé entre le réseau de tension continue (4) d'une part et le circuit de pilotage (1) et le circuit de correction (2) d'autre part.

12. Circuit selon l'une des revendications ci-dessus, **caractérisé en ce qu'**il présente plusieurs actionneurs piézo-électriques (P1 à Pn) et un dispositif de commutation (6) pouvant être piloté par le circuit de commande (3), de sorte qu'il est possible de commander à quel actionneur piézo-électrique (P1 à Pn) le signal de pilotage (S) est transmis.

13. Circuit selon la revendication 12, **caractérisé en ce qu'**il est également possible de commander, au moyen du dispositif de commutation (6), à quel actionneur piézo-électrique (P1 à Pn) le signal de correction (I1, I2) est transmis.

14. Circuit selon l'une des revendications ci-dessus, **caractérisé en ce qu'**il est utilisé pour commander l'injection dans une machine motrice à combustion.
